# EUROPEAN PATENT APPLICATION

(11) **EP 4 693 294 A1**
(43) Date of publication of application: **11.02.2026**
(21) Application number: 23936479.7
(22) Date of filing: 19.12.2023
(51) Int. Cl.: G11C 11/22, G11C 11/409

(54) **MEMORY AND ELECTRONIC DEVICE**

(30) Priority: 06.05.2023 CN 202310512167
(71) Applicant: Huawei Technologies Co., Ltd., Shenzhen, Guangdong 518129 (CN)
(72) Inventor: WANG, Chao, Shenzhen, Guangdong 518129 (CN); LV, Hangbing, Shenzhen, Guangdong 518129 (CN); WANG, Xiao, Shenzhen, Guangdong 518129 (CN); XU, Jeffrey Junhao, Shenzhen, Guangdong 518129 (CN)
(74) Representative: Pfenning, Meinig & Partner mbB
(86) International application number: PCT/CN2023/139969
(87) International publication number: WO 2024/230175

(57) **Abstract**

Embodiments of this application provide a memory and an electronic device, and relate to the field of semiconductor technologies, to provide a high-performance memory. The memory includes a plurality of first bit lines, at least one second bit line, a plurality of plate lines, a plurality of memory cells, and a plurality of transistors. The plurality of first bit lines all extend in a first direction. The at least one second bit line extends in a second direction. The plurality of plate lines all extend in the second direction, the memory cell includes a selector and a capacitor that are coupled in series, the plurality of memory cells are arranged in a plurality of rows and a plurality of columns, and a row direction is parallel to the first direction. In a third direction, the plurality of first bit lines and the plurality of plate lines are located on two sides of the memory cell, each first bit line is coupled to at least two memory cells located in a same row, and each plate line is coupled to at least two memory cells located in a same column. A plurality of first electrodes of the plurality of transistors are correspondingly coupled to the plurality of first bit lines, and a plurality of second electrodes of the plurality of transistors are correspondingly coupled to the at least one second bit line.

## Description

This application claims priority to Chinese Patent Application No. 202310512167.5, filed with the China National Intellectual Property Administration on May 6, 2023 and entitled "MEMORY AND ELECTRONIC DEVICE", which is incorporated herein by reference in its entirety.

### TECHNICAL FIELD

This application relates to the field of semiconductor technologies, and in particular, to a memory and an electronic device.

### BACKGROUND

A memory is an apparatus for information storage. Generally, information is digitized and then stored in a medium that uses an electrical, magnetic, or optical manner. A ferroelectric random access memory (ferroelectric random access memory, FRAM) is a new type of memory. Compared with a conventional memory like a dynamic random access memory (dynamic random access memory, DRAM) or a flash memory, the ferroelectric random access memory is widely used because of advantages like a low read/write voltage, low power consumption, a small device size, a high read/write speed, good cycle performance, radiation resistance, and non-volatility.

Factors such as storage density of the memory and sensitivity of a memory cell in the memory affect performance of the memory.

### SUMMARY

Embodiments of this application provide a memory and an electronic device, to provide a high-performance memory.

To achieve the foregoing objective, this application uses the following technical solutions:
According to a first aspect of embodiments of this application, a memory array is provided. The memory array may be used in a memory, and the memory may be, for example, a ferroelectric random access memory (ferroelectric random access memory, FRAM). The memory includes a plurality of first bit lines, at least one second bit line, a plurality of plate lines, a plurality of memory cells, and a plurality of transistors. The plurality of first bit lines all extend in a first direction. The at least one second bit line extends in a second direction, and the second direction intersects (for example, is perpendicular to) the first direction. The plurality of plate lines all extend in the second direction, the memory cell includes a selector and a capacitor that are coupled in series, the plurality of memory cells are arranged in a plurality of rows and a plurality of columns, and a row direction is parallel to the first direction. In a third direction, the plurality of first bit lines and the plurality of plate lines are located on two sides of the memory cell, each first bit line is coupled to at least two memory cells located in a same row, and each plate line is coupled to at least two memory cells located in a same column. The third direction intersects (for example, is perpendicular to) both the first direction and the second direction. A plurality of first electrodes of the plurality of transistors are correspondingly coupled to the plurality of first bit lines, and a plurality of second electrodes of the plurality of transistors are correspondingly coupled to the at least one second bit line.

In the memory provided in this embodiment of this application, the memory cell is of a 1S1C structure including the selector and the capacitor, and the selector is used as a switch to control whether to select a memory cell. In comparison with a memory cell of a 1T1C structure, the memory cell of the 1S1C structure does not need to have a corresponding transistor disposed in each memory cell. This can reduce a quantity of transistors, and help improve storage density of the memory. In addition, dependence on an advanced process node can be reduced, and process difficulty and process costs can be reduced. In addition, in the memory, a front end of a memory array has a first-level switch transistor, and the transistor is configured to select the memory array. In an architecture of the memory provided in this embodiment of this application, a second electrode of each transistor is coupled to one first bit line, and each first bit line is coupled to at least two memory cells. Because the selector is a two-terminal device, the selector is turned on only when a piezoelectric difference between two terminals of the selector is greater than a specific value. In this case, even if a same transistor simultaneously transmits a read/write signal to the first bit lines of the plurality of memory cells, a plate line of an unselected memory cell is not used to transmit the read/write signal, and the unselected memory cell is not turned on. This can effectively avoid crosstalk. Furthermore, both the memory cell and the transistor in this application may be manufactured by using a conventional process, and are highly compatible with the conventional process and a conventional architecture. Therefore, process difficulty is low. Therefore, according to the memory provided in this embodiment of this application, both high storage density and anti-crosstalk performance can be considered, and performance of the memory can be improved.

In a possible implementation, in the third direction, the plurality of memory cells are further distributed in a plurality of layers.

In this embodiment of this application, because no transistor needs to be disposed in the memory cell, a small quantity of transistors are disposed in a region under the memory cells. Therefore, even if the memory cells are stacked in a three-dimensional manner in the third direction, the region under the memory cells is sufficient to dispose transistors required in the memory. The memory cells are stacked in the three-dimensional manner in the third direction, so that a quantity of memory cells may be increased, but an area occupied by the memory cells in a plane parallel to a substrate is not increased. This can increase a quantity of disposed memory cells in a unit area, and help improve the storage density of the memory.

In a possible implementation, transistors coupled to a same second bit line are coupled to a first bit line located at a same layer.

In this way, crosstalk caused by sharing of a second bit line by memory cells at different layers can be avoided.

In a possible implementation, the memory further includes at least one word line, and a plurality of control electrodes of the plurality of transistors are correspondingly coupled to the at least one word line. The word line is coupled to the control electrode of the transistor, and is configured to control a selected memory array in which a part of memory cells are located to work.

In a possible implementation, at least two transistors are coupled to each word line.

In this way, each word line simultaneously controls the at least two transistors. This can reduce a quantity of word lines, and simplify a structure of the memory.

In a possible implementation, transistors coupled to a same word line are coupled to a first bit line located at a same layer.

In this way, crosstalk caused by sharing of a word line by memory cells at different layers can be avoided.

In a possible implementation, the first bit line is coupled to the first electrode of the transistor through a conductive via. At a same layer, an end of at least one first bit line is recessed relative to an end of a first bit line adjacent to the at least one first bit line to form a recessed region; and the conductive via that starts to extend from a side that is of the recessed region and that is away from the transistor passes through the recessed region.

When a layer of memory cells are arranged in a manner of arranging two adjacent rows of memory cells in a staggered manner, a column of memory cells are not arranged in alignment. Therefore, the ends of the first bit lines may also be arranged in the non-flush manner, to form the recessed region. On this basis, the conductive via is coupled to the transistor by passing through the recessed region. This can reduce an area occupied by the conductive via, and help improve the storage density of the memory.

In a possible implementation, two adjacent layers of memory cells share the plate line.

The two adjacent layers of memory cells are enabled to share the plate line, so that a quantity of wiring layers can be reduced, to simplify the structure of the memory, and further improve the storage density of the memory.

In a possible implementation, each layer of memory cells are coupled to a first bit line located on a side that is of the memory cell and that is close to a transistor.

In this way, the memory cell is located over the first bit line, and the conductive via is located under the first bit line. In this case, on one hand, the memory cell may also be arranged above the conductive via, to further improve the storage density of the memory. On the other hand, in contrast to arranging the first bit line over the memory cell, arranging the first bit line under the memory cell may make the conductive via close to the substrate, and the conductive via has a shallow depth. A preparation process is simple.

In a possible implementation, two adjacent layers of memory cells share the first bit line.

The two adjacent layers of memory cells are enabled to share the first bit line, so that a quantity of wiring layers can be reduced, to simplify the structure of the memory, and further improve the storage density of the memory.

In a possible implementation, memory cells located in a same row are correspondingly coupled to at least two first bit lines.

When a process of coupling a plurality of memory cells to one first bit line is difficult to implement, the memory cells in the same row may be correspondingly coupled to the at least two first bit lines, to reduce process difficulty. However, because the quantity of transistors in the memory provided in this embodiment of this application is small, correspondingly coupling the memory cells in the same row to the at least two first bit lines may not reduce the storage density of the memory.

In a possible implementation, at least two transistors are coupled in parallel to each second bit line.

In this way, each second bit line is used to simultaneously transmit a signal for the at least two memory cells. This can reduce a quantity of second bit lines, and simplify the structure of the memory.

In a possible implementation, an equivalent area of the selector is less than an equivalent area of the capacitor.

The equivalent area of the selector is less than the equivalent area of the capacitor. In this case, when a write operation is performed, because a capacitance of the selector is small, the selector may obtain larger instantaneous voltage division at a moment at which an operating voltage is applied, so that an upper limit of an on-state threshold voltage of the selector is increased, and a window of the on-state threshold voltage is increased, which are conducive to turning on the selector. In addition, the on-state threshold voltage may be greater than a crosstalk voltage, and both read/write performance and anti-crosstalk performance are considered, thereby improving a crosstalk problem. In addition, when the equivalent area of the selector is set to be less than the equivalent area of the capacitor, a resistance of the selector is small, and a current flowing to the capacitor increases, so that a polarization switching speed in the capacitor can be accelerated, thereby accelerating a read/write speed. In addition, a ratio of the capacitance of the selector to a capacitance of the capacitor is adjusted by adjusting a ratio of an area of the selector to an area of the capacitor, which is easy to implement and has a large adjustable range of the capacitance ratio. Furthermore, the area of the capacitor is as large as possible, to allow the capacitor to switch as much charge as possible. However, the area of the selector is as small as possible, so that an off-state resistance of the selector may be increased, and the selector in an off state may effectively limit flow of a charge in the memory cell, thereby reducing shunting of a read current. In this way, a quantity of memory cells connected in parallel to a same first bit line can be increased, and the storage density of the memory can be increased.

In a possible implementation, projection of the selector in a plane parallel to the first direction and the second direction coincides with projection of the capacitor in the plane.

A structure of the capacitor is adjusted, so that the equivalent area of the capacitor is greater than the equivalent area of the selector, but an occupied area of the capacitor is the same as an occupied area of the selector, to reduce an occupied area of the memory cell and improve the storage density of the memory.

In a possible implementation, the capacitor includes a ferroelectric capacitor.

The ferroelectric capacitor has remnant polarization. In comparison with a dielectric capacitor, including the ferroelectric capacitor by the memory cell may further increase a storage window and improve accuracy of writing. In addition, the ferroelectric capacitor has a good retention characteristic, and therefore can implement non-volatile storage.

In a possible implementation, the capacitor includes a first electrode, a ferroelectric layer, and a second electrode. The first electrode is columnar, the second electrode is located at a periphery of the first electrode, and the ferroelectric layer is located between the first electrode and the second electrode.

The capacitor is made into a column shape, which occupies a small area and has a large equivalent area, and is conducive to improving the storage density.

In a possible implementation, two adjacent rows of memory cells are arranged in a staggered manner.

When the two adjacent rows of memory cells are arranged in the staggered manner, a distance between memory cells in the two adjacent rows is a distance from a center of one memory cell to a center of the other memory cell, and the distance is a diagonal. According to the triangle side-length law, a length of a straight line is less than a length of the diagonal. Therefore, the length of the diagonal meets a spacing requirement, so that the length of the straight line can be reduced, to improve arrangement density of the memory cells in the second direction, thereby improving arrangement density of the memory cells.

In a possible implementation, the memory further includes a controller, and the controller is coupled to at least one of the second bit line, the plate line, and the word line.

In a possible implementation, the selector includes a resistive switching layer, a third electrode, and a fourth electrode, and the resistive switching layer is disposed between the third electrode and the fourth electrode. The selector that is the two-terminal device has a simple structure, and occupies a small area.

According to a second aspect of embodiments of this application, an electronic device is provided, including: a circuit board and the memory according to any one of the first aspect, where the circuit board is coupled to the memory.

### BRIEF DESCRIPTION OF DRAWINGS

To describe technical solutions in this application more clearly, the following briefly describes accompanying drawings for describing some embodiments of this application. It is apparent that the accompanying drawings in the following descriptions are merely accompanying drawings in some embodiments of this application. For a person of ordinary skill in the art, other accompanying drawings may further be derived from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a diagram of an architecture of an electronic device according to an embodiment of this application;
FIG. 2 is an exploded view of an electronic device according to an embodiment of this application;
FIG. 3 is a diagram of an architecture of a memory according to an embodiment of this application;
FIG. 4 is a circuit diagram of a memory cell according to an embodiment of this application;
FIG. 5 is a three-dimensional diagram of a memory according to an embodiment of this application;
FIG. 6 is a cross-sectional view along a direction from A1 to A2 in FIG. 5;
FIG. 7A and FIG. 7B are diagrams of arrangement manners of memory cells according to embodiments of this application;
FIG. 8A to FIG. 8C are diagrams of structures of a capacitor according to embodiments of this application;
FIG. 9 is a three-dimensional diagram of a memory according to an embodiment of this application;
FIG. 10 is a cross-sectional view along a direction from B1 to B2 in FIG. 9;
FIG. 11 is a three-dimensional diagram of a memory according to an embodiment of this application;
FIG. 12 is a cross-sectional view along a direction from C1 to C2 in FIG. 11;
FIG. 13 is a three-dimensional diagram of a memory according to an embodiment of this application; and
FIG. 14 is a cross-sectional view along a direction from D1 to D2 in FIG. 13.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms such as "second" and "first" below are only for ease of description, and cannot be understood as indicating or implying relative importance or implicitly indicating a quantity of indicated technical features. Therefore, a feature limited by "second", "first", or the like may explicitly or implicitly include one or more features. In descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts. They are used for description and clarification of relative positions, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact, or may be indirect contact through an intermediate medium.

In embodiments of this application, "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects.

An embodiment of this application provides an electronic device. The electronic device is, for example, a consumer electronic product, a home electronic product, a vehicle-mounted electronic product, a financial terminal product, or a communication electronic product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smartwatch or a smart band), a virtual reality (virtual reality, VR) terminal device, an augmented reality (augmented reality, AR) terminal device, or an uncrewed aerial vehicle. The home electronic product is, for example, a smart door lock, a television, a remote control, a refrigerator, or a small charging home appliance (for example, a soy milk maker or a robot vacuum). The vehicle-mounted electronic product is, for example, a vehicle-mounted navigator or a vehicle-mounted high-density digital video disc (digital video disc, DVD). The financial terminal product is, for example, an automated teller machine (automated teller machine, ATM) or a terminal for self-help service handling. The communication electronic product is, for example, a communication device like a server, a memory, a radar, or a base station.

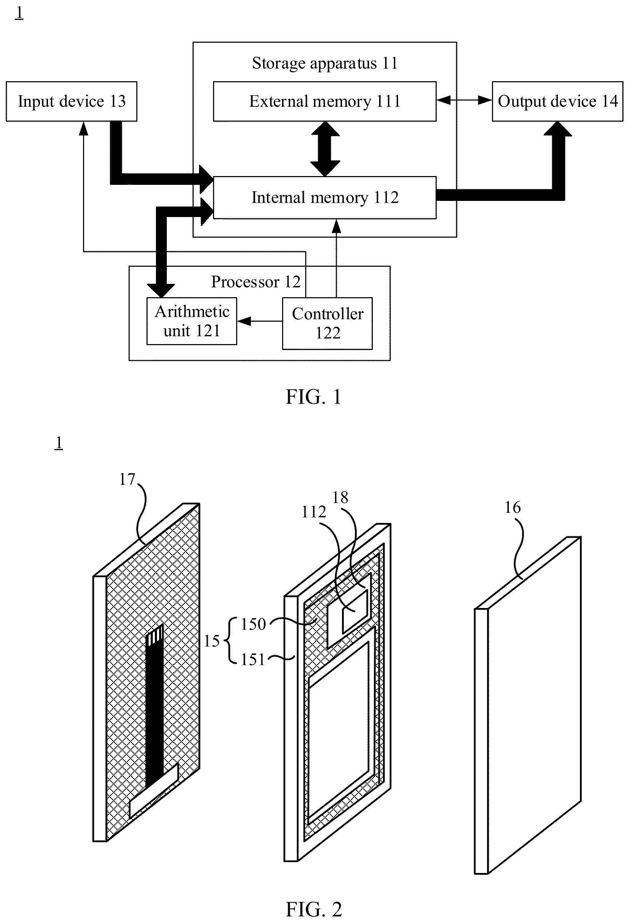

FIG. 1 is a diagram of an architecture of an electronic device according to an embodiment of this application.

For example, the electronic device is shown in FIG. 1. An electronic device 1 includes components such as a storage apparatus 11, a processor 12, an input device 13, and an output device 14. A person skilled in the art may understand that an architecture of the electronic device 1 shown in FIG. 1 does not constitute a limitation on the electronic device 1. The electronic device 1 may include more or fewer components than those shown in FIG. 1, or may combine some of the components shown in FIG. 1. Alternatively, component arrangement may be different from that shown in FIG. 1.

The storage apparatus 11 is configured to store a software program and a module. The storage apparatus 11 mainly includes a program storage area and a data storage area. The program storage area may store and back up an operating system, an application required by at least one function (such as a sound play function or an image play function), and the like. The data storage area may store data (such as audio data, image data, and a phone book) created based on use of the electronic device 1, and the like. In addition, the storage apparatus 11 includes an external memory 111 and an internal memory 112. Data stored in the external memory 111 and the internal memory 112 may be transmitted to each other. The external memory 111 may include, for example, a hard disk, a USB flash drive, and a floppy disk. The internal memory 112 may include, for example, a random access memory (random access memory, RAM) and a read-only memory (read-only memory, ROM). The random access memory may include, for example, a ferroelectric memory, a phase-change memory, or a magnetic memory.

The processor 12 is a control center of the electronic device 1, is connected to all parts of the entire electronic device 1 through various interfaces and lines, and performs various functions and data processing of the electronic device 1 by running or executing the software program and/or the module stored in the storage apparatus 11 and invoking data stored in the storage apparatus 11. In this way, overall monitoring is performed on the electronic device 1. Optionally, the processor 12 may include one or more processing units. For example, the processor 12 may include an application processor (application processor, AP), a modem processor, and a graphics processing unit (graphics processing unit, GPU). Different processing units may be independent components, or may be integrated into one or more processors. For example, the processor 12 may integrate the application processor and the modem processor. The application processor mainly processes an operating system, a user interface, an application, and the like. The modem processor mainly processes wireless communication. It may be understood that the modem processor may be not integrated into the processor 12. The application processor may be, for example, a central processing unit (central processing unit, CPU). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write the data.

The input device 13 is configured to receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory like a finger or a stylus pen), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to output a signal corresponding to data that is input by the input device 13 and stored in the internal memory 112. For example, the output device 14 outputs a sound signal or a video signal. The controller 122 in the processor 12 may further control the output device 14 to output a signal or not to output a signal.

It should be noted that a thick arrow in FIG. 1 indicates data transmission, and a direction of the thick arrow indicates a data transmission direction. For example, a unidirectional arrow between the input device 13 and the internal memory 112 indicates that data received by the input device 13 is transmitted to the internal memory 112. For another example, a bidirectional arrow between the arithmetic unit 121 and the internal memory 112 indicates that the data stored in the internal memory 112 may be transmitted to the arithmetic unit 121, and data processed by the arithmetic unit 121 may be transmitted to the internal memory 112. A thin arrow in FIG. 1 indicates a component that can be controlled by the controller 122. For example, the controller 122 may control the external memory 111, the internal memory 112, the arithmetic unit 121, the input device 13, the output device 14, and the like.

For ease of further describing a structure of the electronic device 1, the following uses an example in which the electronic device 1 is a mobile phone for description.

FIG. 2 is a diagram of a framework of an electronic device according to an embodiment of this application.

As shown in FIG. 2, the electronic device 1 may further include a middle frame 15, a rear housing 16, and a display 17. The rear housing 16 and the display 17 are respectively located on two opposite sides of the middle frame 15, and the middle frame 15 and the display 17 are disposed in the rear housing 16. The middle frame 15 includes a bearing plate 150 configured to bear the display 17, and a frame 151 that surrounds the bearing plate 150.

Still refer to FIG. 2. The electronic device 1 may further include a circuit board 18. The circuit board 18 is disposed on a side that is of the bearing plate 150 and that is close to the rear housing 16. An internal memory 112 in the electronic device 1 may be disposed on the circuit board 18. The internal memory 112 is electrically connected to the circuit board 18.

A memory may be classified into a volatile memory and a non-volatile memory. A dynamic random access memory (dynamic random access memory, DRAM) occupies a large market share because of advantages of fast read/write speed and strong durability. However, with the rapid development of the internet of things, big data, and artificial intelligence, a small storage capacity and high power consumption of the dynamic random access memory cannot meet requirements.

As a new type of memory, a ferroelectric memory has become one of mainstream internal memories because of features such as non-volatile data storage, a fast access rate, a low read/write voltage, low power consumption, a small device size, good durability, non-volatility, good cycle performance, and radiation resistance.

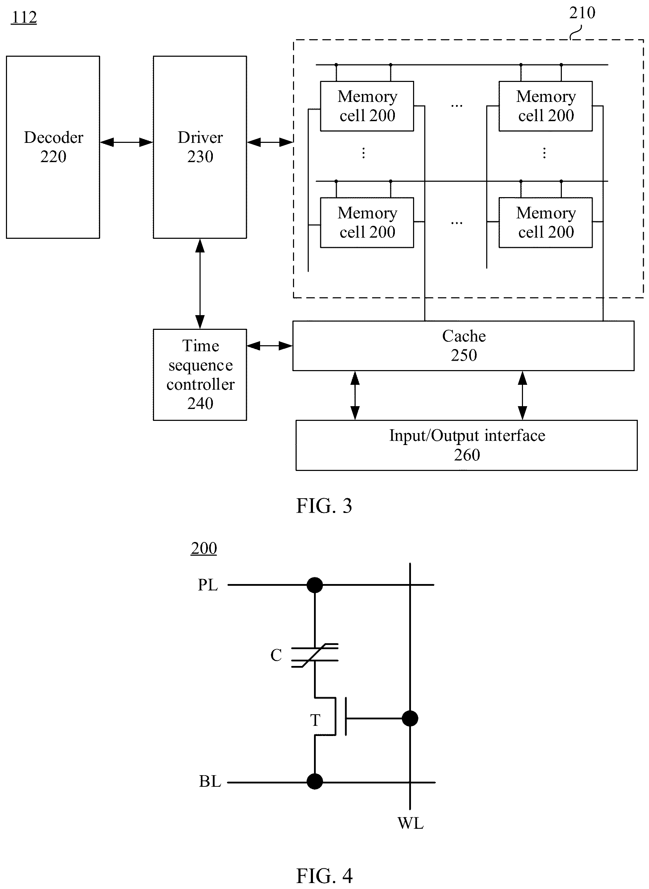

FIG. 3 is a diagram of an architecture of a memory according to an embodiment of this application.

As shown in FIG. 3, an internal memory 112 includes a memory array 210, a decoder 220, a driver 230, a controller (a time sequence controller) 240, a cache 250, and an input/output interface 260. The memory array 210 includes a plurality of memory cells (cell) 200 arranged in an array.

FIG. 4 is a diagram of a topology of the memory cell according to an embodiment of this application.

As shown in FIG. 4, the memory cell 200 includes a capacitor-based circuit architecture. The memory cell 200 has a 1T1C (1-transistor-1-capacitor) structure. To be specific, the memory cell 200 includes one transistor T and one capacitor C, a source of the transistor T is electrically connected to a bit line (bit line, BL), a drain is electrically connected to an electrode of the capacitor C, a gate is electrically connected to a word line (word line, WL), and the other electrode of the capacitor C is electrically connected to a plate line (plate line, PL). The circuit architecture of the memory cell 200 in embodiments of this application is not limited thereto.

Based on this, the decoder 220 in FIG. 3 may perform decoding based on a received address, to determine a memory cell 200 that needs to be accessed in the memory array 210. The driver 230 is configured to generate a control signal based on a decoding result output by the decoder 220. The control signal is transmitted to the gate of the transistor T in the memory cell 200 by using the word line WL, to control the transistor T to be conducted or cut off, to access the specified memory cell 200. The cache 250 receives, by using the plate line PL, a data signal output by the memory cell 200, and is configured to buffer the data signal. For example, the data signal may be buffered in a first-in first-out (first-in first-out, FIFO) manner. The time sequence controller 240 is configured to control a time sequence of the cache 250, and control the drive 230 to drive the memory array 210. The input/output interface 260 is configured to transmit a data signal, for example, receive the data signal or send the data signal.

The memory array 210, the decoder 220, the driver 230, the time sequence controller 240, the cache 250, and the input/output interface 260 may be integrated into one chip, or may be respectively integrated into a plurality of chips.

When a memory cell 200 in the memory array 210 is selected to perform a read/write operation, unselected memory cells 200 that are located on a same bit line BL as the memory cell 200 have non-zero voltage offsets, and the voltage offsets change information stored in these unselected memory cells 200. Consequently, stability of the memory is affected.

To resolve a problem of crosstalk between the memory cells 200, the transistor T is added to the memory cell 200 shown in FIG. 4. To be specific, the memory cell 200 is a storage structure of one transistor T and one capacitor C (one transistor and one (ferroelectric) capacitor, 1T1C) or one transistor T and n capacitors C (one transistor and n (ferroelectric) capacitors, 1TnC).

However, after a transistor T is added to each memory cell 200, storage density of the memory cell 200 is greatly reduced. In particular, a process of a dynamic random access memory DRAM is approaching a scaling limit, and storage density of the dynamic random access memory is limited by leakage of a ferroelectric capacitor. Therefore, use of a 1T1C or 1TnC structure further increases a challenge faced by the dynamic random access memory DRAM in terms of storage density. Therefore, it is important to design a new memory to resolve a crosstalk problem without sacrificing storage density, and improve performance of the memory.

The following uses several examples to describe the memory provided in embodiments of this application.

### Example 1

Example 1 is illustrated by using an example in which the memory cells in the memory are distributed in two dimensions and have only one layer in a thickness direction.

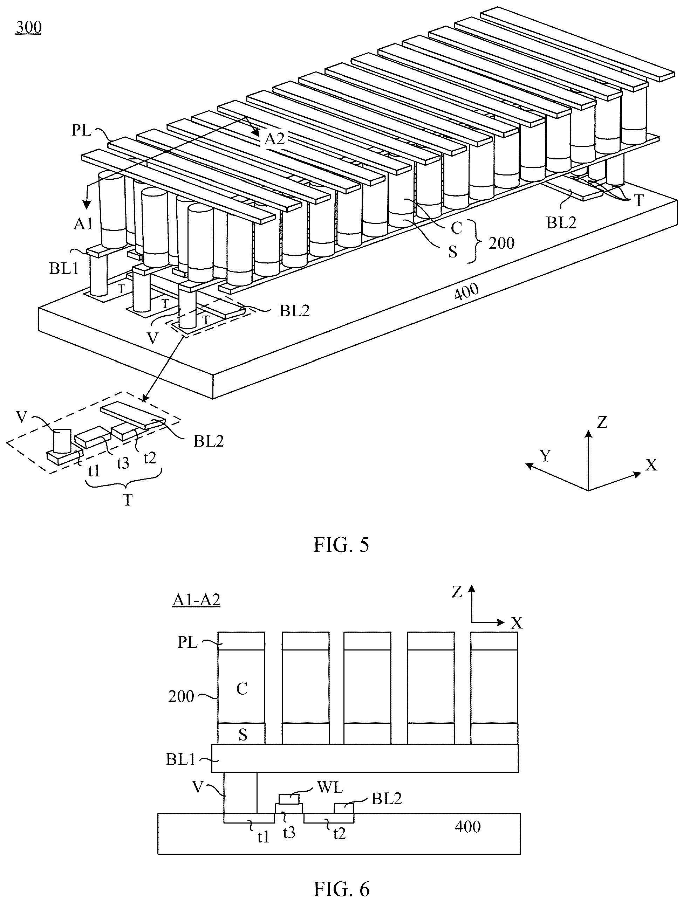

FIG. 5 is a diagram of a structure of a memory according to an embodiment of this application. FIG. 6 is a cross-sectional view along a direction from A1 to A2 in FIG. 5.

With reference to FIG. 5 and FIG. 6, an embodiment of this application further provides a memory 300. The memory 300 includes first bit lines BL1, a second bit line BL2, plate lines PLs, a word line WL (not shown in FIG. 5), memory cells 200, and transistors T.

In some embodiments, the memory 300 further includes a substrate 400, and the first bit lines BL1, the second bit line BL2, the plate lines PLs, the word line WL, the memory cells 200, and the transistors T are all disposed on one side of the substrate 400.

In some embodiments, the plurality of first bit lines BL1 all extend in a first direction X.

For example, the plurality of first bit lines BL1 are distributed at one layer, each first bit line BL1 extends in the first direction X, and the plurality of first bit lines BL1 are disposed in parallel.

It should be noted herein that an extension track of the first bit line BL1 may be a straight line, or the extension track of the first bit line BL1 may be a curve or a polyline. This is not limited in embodiments of this application, provided that an overall extension trend of the first bit line BL1 extends towards the first direction X.

In addition, the plurality of first bit lines BL1 may be extended in parallel. Parallelism in this embodiment of this application is not limited to absolute parallelism. Approximate parallelism or fluctuation within a process error range (for example, +5°) belongs to parallelism in this embodiment of this application. Certainly, the plurality of first bit lines BL1 may not be extended in parallel.

Certainly, lengths of the plurality of first bit lines BL1 in the first direction X may be equal or may not be equal. Similarly, widths of the plurality of first bit lines BL1 may be equal or may not be equal.

A manner of disposing the plurality of first bit lines BL1 is not limited in embodiments of this application, provided that the plurality of first bit lines BL1 are insulated from each other. All manners of disposing a plurality of first bit lines BL1 in a related technology are applicable to this embodiment of this application.

In some embodiments, the memory 300 includes at least one second bit line BL2.

For example, each second bit line BL2 extends in a second direction Y.

The second direction Y intersects with the first direction X. For example, the second direction Y is perpendicular to the first direction X, and both the second direction Y and the first direction X are parallel to the substrate 400.

It should be noted herein that an extension track of the second bit line BL2 may be a straight line, or the extension track of the second bit line BL2 may be a curve or a polyline. This is not limited in embodiments of this application, provided that an overall extension trend of the second bit line BL2 extends towards the second direction Y.

For example, the memory 300 may include one second bit line BL2, or the memory 300 may include a plurality of second bit lines BL2. When the memory 300 includes the plurality of second bit lines BL2, the plurality of second bit lines BL2 may be insulated from each other, or a part or all of the plurality of second bit lines BL2 may be coupled at a location, to receive a same signal. In FIG. 5, an example in which the memory 300 includes two second bit lines BL2 is used for illustration. The two second bit lines BL2 may be coupled or not coupled at a location of the memory 300.

For example, the first bit line BL1 in the memory 300 may be understood as a local bit line (local bit line, LBL) commonly referred to in the art, and the second bit line BL2 in the memory 300 may be understood as a global bit line (global bit line, GBL) commonly referred to in the art.

In some embodiments, the plurality of plate lines PLs all extend in the second direction Y.

For example, the plurality of plate lines PLs are distributed at one layer, each plate line PL extends in the second direction Y, and the plurality of plate lines PLs are disposed in parallel.

It should be noted herein that an extension track of the plate line PL may be a straight line, or the extension track of the plate line PL may be a curve or a polyline. This is not limited in embodiments of this application, provided that an overall extension trend of the plate line PL extends towards the second direction Y.

In addition, the plurality of plate lines PLs may be extended in parallel. Parallelism in this embodiment of this application is not limited to absolute parallelism. Approximate parallelism or fluctuation within the process error range (for example, +5°) belongs to parallelism in this embodiment of this application. Certainly, the plurality of plate lines PLs may not be extended in parallel.

Certainly, lengths of the plurality of plate lines PLs in the second direction Y may be equal or may not be equal. Similarly, widths of the plurality of plate lines PLs may be equal or may not be equal.

A manner of disposing the plurality of plate lines PLs is not limited in embodiments of this application, provided that the plurality of plate lines PLs are insulated from each other. All manners of disposing a plurality of plate lines PLs in the related technology are applicable to this embodiment of this application.

In some embodiments, the memory 300 includes at least one word line WL.

For example, each word line WL extends in the second direction Y.

It should be noted herein that an extension track of the word line WL may be a straight line, or the extension track of the word line WL may be a curve or a polyline. This is not limited in embodiments of this application, provided that an overall extension trend of the word line WL extends towards the second direction Y.

For example, the memory 300 may include one word line WL, or the memory 300 may include a plurality of word lines WLs. When the memory 300 includes the plurality of word lines WLs, the plurality of word lines WLs may be insulated from each other, or a part or all of the plurality of word lines WLs may be coupled at a location, to receive a same signal.

Continue to refer to FIG. 5. In some embodiments, in a plane parallel to the substrate 400, the plurality of memory cells 200 are arranged in a plurality of rows and a plurality of columns, and in a third direction Z perpendicular to the substrate 400, the memory cells 200 are arranged at one layer.

Certainly, extension directions and layout manners of the plurality of first bit lines BL1, the at least one second bit line BL2, the plurality of plate lines PLs, and the at least one word line WL that are included in the memory 300 are not limited in embodiments of this application. The foregoing is merely an example, provided that the plurality of first bit lines BL1, the at least one second bit line BL2, the plurality of plate lines PLs, and the at least one word line WL are insulated from each other.

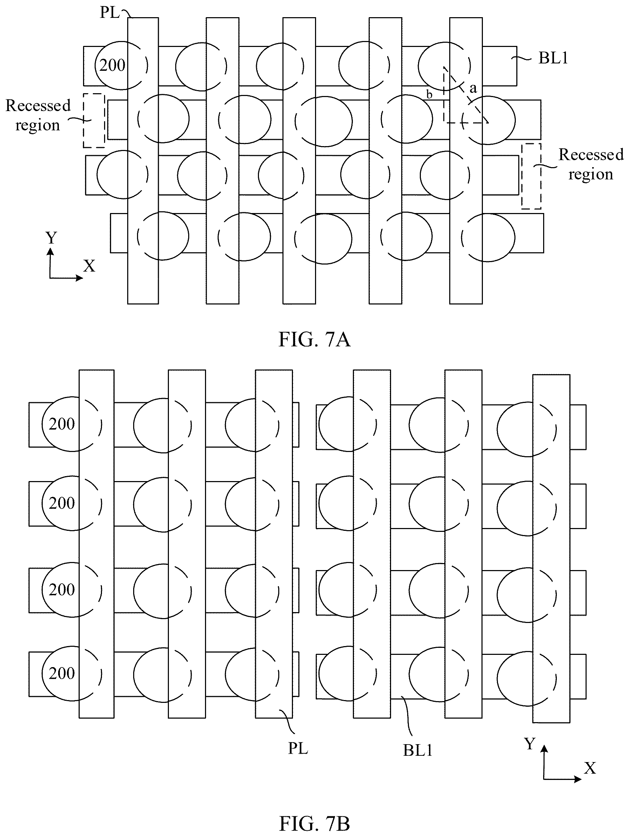

FIG. 7A and FIG. 7B are diagrams of arrangement manners of the memory cells 200 according to embodiments of this application.

In some embodiments, as shown in FIG. 7A, a row arrangement direction of the memory cells 200 is parallel to the first direction X, and a column direction is not parallel to the second direction Y.

In this case, the memory cells 200 are arranged in a polyline in the column direction, or it is understood that two adjacent rows of memory cells 200 are arranged in a staggered manner.

For example, the memory cells 200 are arranged in a honeycomb (honeycomb) manner.

When the two adjacent rows of memory cells 200 are arranged in the staggered manner, a distance between memory cells 200 in the two adjacent rows is a distance from a center of one memory cell 200 to a center of the other memory cell 200, and the distance is a diagonal a. According to the triangle side-length law, a length of a straight line b is less than a length of the diagonal a. Therefore, the length of the diagonal a meets a spacing requirement, so that the length of the straight line b can be reduced, to improve arrangement density of the memory cells 200 in the second direction Y, thereby improving arrangement density of the memory cells 200.

In some other embodiments, as shown in FIG. 7B, a row arrangement direction of the memory cells 200 is parallel to the first direction X, and a column direction is parallel to the second direction Y.

In this case, the memory cells 200 are arranged in a straight line in the column direction, and two adjacent rows of memory cells 200 are arranged in alignment.

For example, the memory cells 200 are arranged in a square array manner.

In this way, a layout is simple and a process is simple.

It should be noted that a shape of projection of the memory cell 200 on the substrate 400 is not limited in embodiments of this application. The projection of the memory cell 200 on the substrate 400 may be any closed shape. In FIG. 7A, only an example in which the projection of the memory cell 200 on the substrate 400 is a circle is used for illustration.

In addition, regardless of an arrangement manner used by the memory cells 200, ends of the plurality of first bit lines BL1 may be flush, or may be uneven, as shown in FIG. 7A. Similarly, ends of the plurality of plate lines PLs may be flush, as shown in FIG. 7A, or may be uneven.

Continue to refer to FIG. 5. The plurality of first bit lines BL1 and the plurality of plate lines PLs in the memory 300 are located on two sides of the memory cell 200.

For example, in the third direction Z, the plurality of first bit lines BL1 and the plurality of plate lines PLs are located on the two sides of the memory cell 200. To be specific, a type of lines in the plurality of first bit lines BL1 and the plurality of plate lines PLs are located on a side that is of the memory cell 200 and that is close to the substrate 400, and are coupled to the memory cell 200; and the other type of lines in the plurality of first bit lines BL1 and the plurality of plate lines PLs are located on a side that is of the memory cell 200 and that is away from the substrate 400, and are coupled to the memory cell 200.

In some embodiments, the memory cell 200 is located on a side that is of a first bit line BL1 coupled to the memory cell 200 and that is away from a transistor T.

For example, as shown in FIG. 5, the plurality of first bit lines BL1 are disposed on the side that is of the memory cell 200 and that is close to the substrate 400, and the plurality of plate lines PLs are disposed on the side that is of the memory cell 200 and that is away from the substrate 400.

In this way, the memory cell 200 is located over the first bit line BL1, and a conductive via V is located under the first bit line BL1. In this case, on one hand, the memory cell 200 may also be arranged above the conductive via V, to further improve storage density of the memory 300. On the other hand, in contrast to arranging the first bit line BL1 over the memory cell 200, arranging the first bit line BL1 under the memory cell 200 may make the conductive via V close to the substrate 400, and the conductive via V has a shallow depth. A preparation process is simple.

Continue to refer to FIG. 5. Each first bit line BL1 is coupled to at least two memory cells 200 in a same row.

In some embodiments, as shown in FIG. 7A, an example in which memory cells 200 in a same row are coupled to a same first bit line BL1 is used for illustration. In this case, a quantity of first bit lines BL1 is the same as a quantity of rows of memory cells 200.

In some other embodiments, as shown in FIG. 7B, memory cells 200 located in a same row are correspondingly coupled to at least two first bit lines BL1, and the at least two first bit lines BL1 may be, for example, located on a same extension line. In this case, a quantity of first bit lines BL1 is different from a quantity of rows of memory cells 200.

For example, in the memory cells 200 in the same row, a memory cell 200 in a left half part is coupled to one first bit line BL1, and a memory cell 200 in a right half part is coupled to another first bit line BL1.

When a process of coupling a plurality of memory cells 200 to one first bit line BL1 is difficult to implement, the memory cells 200 in the same row may be correspondingly coupled to the at least two first bit lines BL1, to reduce process difficulty. However, because a quantity of transistors T in the memory 300 provided in this embodiment of this application is small, correspondingly coupling the memory cells 200 in the same row to the at least two first bit lines BL1 may not reduce the storage density of the memory 300.

Similarly, each plate line PL is coupled to at least two memory cells 200 located in a same column. In FIG. 5 and FIG. 7A, an example in which memory cells 200 located in a same column are coupled to a same plate line PL is used for illustration. In this case, a quantity of plate lines PLs is the same as a quantity of columns of memory cells 200. Memory cells 200 located in a same column may also be correspondingly coupled to at least two plate lines PLs, and the at least two plate lines PLs may be, for example, located on a same extension line. In this case, a quantity of plate lines PLs is different from a quantity of columns of memory cells 200.

For a structure of the memory cell 200, in some embodiments, as shown in FIG. 5, the memory cell 200 includes a selector S and a capacitor C that are coupled in series. The memory cell 200 in this embodiment of this application may be understood as a structure of one selector and one capacitor (one selector and one (ferroelectric) capacitor, 1S1C).

The memory cell 200 is a two-terminal memory cell. Either terminal of the memory cell 200 may be connected to the plate line PL, and the other terminal is connected to the first bit line BL1. In other words, one of the selector S and the capacitor C is coupled to the plate line PL, and the other of the selector S and the capacitor C is coupled to the first bit line BL1.

For example, as shown in FIG. 5, the selector S and the capacitor C are coupled in series between the plate line PL and the first bit line BL1, the capacitor C is coupled to the plate line PL, and the selector S is coupled to the first bit line BL1.

In some embodiments, the selector S is a two-terminal device having on/off functionality, and the selector S has a characteristic of being in a high-resistance state or a low-resistance state as a voltage applied to two terminals of the selector S changes. The selector S is configured to control on and off of the memory cell 200 in which the selector S is located.

The memory cell 200 provided in this embodiment of this application is of the structure of 1S1C, and the selector S is the two-terminal device, so that an area of the memory cell 200 can be reduced, and the storage density of the memory 300 can be improved. In addition, the selector S can reduce crosstalk between the memory cells 200.

In some embodiments, an equivalent area of the selector S is equal to an equivalent area of the capacitor C.

To ensure that the memory cell 200 has a specific capacitance value, the capacitor C needs to be greater than a specific area. As a result, the area of the selector S is also large. In this case, instantaneous relative voltage division is small at a moment at which an external voltage is applied, which is not conducive to turning on the selector S.

In some embodiments, the equivalent area of the selector S is less than the equivalent area of the capacitor C.

A formula for calculating the capacitor is C=ε* S/d, where ε is a dielectric constant of a dielectric between plates, S is an area of the capacitor, and d is a distance between the plates. A method for calculating the equivalent area of the selector S may be the same as a method for calculating the area during capacitance calculation, and a method for calculating the equivalent area of the capacitor C may be the same as the method for calculating the area during capacitance calculation. For example, the equivalent area of the selector S may be an area of an overlapping part between two electrodes in the selector S. The equivalent area of the capacitor C may be an area of an overlapping part between two electrodes in the capacitor C.

The equivalent area of the selector S is less than the equivalent area of the capacitor C. In this case, when a write operation is performed, because a capacitance of the selector S is small, the selector S may obtain larger instantaneous voltage division at a moment at which an operating voltage is applied, so that an upper limit of an on-state threshold voltage of the selector S is increased, and a window of the on-state threshold voltage is increased, which are conducive to turning on the selector S. In addition, the on-state threshold voltage may be greater than a crosstalk voltage, and both read/write performance and anti-crosstalk performance are considered, thereby improving the crosstalk problem. In addition, when the equivalent area of the selector S is set to be less than the equivalent area of the capacitor C, a resistance of the selector S is small, and a current flowing to the capacitor C increases, so that a polarization switching speed in the capacitor C can be accelerated, thereby accelerating a read/write speed. In addition, a ratio of a capacitance of the selector S to a capacitance of the capacitor C is adjusted by adjusting a ratio of the area of the selector S to the area of the capacitor C, which is easy to implement and has a large adjustable range of the capacitance ratio. Furthermore, the area of the capacitor C is as large as possible, to allow the capacitor C to switch as much charge as possible. However, the area of the selector S is as small as possible, so that an off-state resistance of the selector S may be increased, and the selector S in an off state may effectively limit flow of a charge in the memory cell 200, thereby reducing shunting of a read current. In this way, a quantity of memory cells 200 connected in parallel to a same first bit line BL1 can be increased, and the storage density of the memory 300 can be increased.

In some embodiments, a ratio of the capacitance value of the capacitor C to the capacitance value of the selector S is greater than 1 and less than or equal to 1000.

For example, the capacitance value of the capacitor C is 3 times, 3.5 times, 4 times, 4.5 times, 5 times, 5.5 times, 6 times, 10 times, 15 times, 20 times, 25 times, 30 times, 100 times, 150 times, 200 times, 250 times, 300 times, 400 times, 500 times, 600 times, 700 times, 800 times, and 900 times the capacitance value of the selector S.

Because the capacitance of the capacitor C is greater than the capacitance of the selector S, the instantaneous voltage division obtained by the selector S at the moment at which the operating voltage is applied is greater than 1/2 of the operating voltage. In this case, the on-state threshold voltage of the selector S may also be greater than 1/2 of the operating voltage, to ensure that the selector remains in the off state under the crosstalk voltage (1/2 of the operating voltage). Therefore, a read/write speed can be further effectively improved while both the read/write performance and the anti-crosstalk performance can be considered, and the crosstalk problem can be resolved.

In some embodiments, a ratio of the equivalent area of the capacitor C to the equivalent area of the selector S is greater than 3.

For example, the ratio of the equivalent area of the capacitor C to the equivalent area of the selector S is 4, 5, 6, 7, 8, 9, 10, 20, 30, 40, 50, 60, 70, 80, or 90.

In some embodiments, the equivalent area of the selector S is 200 nm² to 4 µm².

For example, the area of the selector S is 1000 nm², 3000 nm², 5000 nm², 7000 nm², 10000 nm², 30000 nm², 50000 nm², or 70000 nm².

The equivalent area of the selector S is set to 200 nm² to 4 µm², which helps reduce a leakage current of the selector, increase the read/write speed, and improve an anti-crosstalk capability when a storage window is increased.

In some embodiments, the equivalent area of the capacitor C is 400 nm² to 4.5 µm².

For example, the equivalent area of the capacitor C is 0.07 µm², 0.1 µm², 0.13 µm², 0.15 µm², 0.17 µm², or 0.2 µm².

The equivalent area of the capacitor C is set to 400 nm² to 4.5 µm², which helps increase remnant polarization strength of the capacitor C and increase the storage window while improving storage density.

Continue to refer to FIG. 7A. In some embodiments, projection of the selector S on the substrate 400 coincides with projection of the capacitor C on the substrate 400.

A structure of the capacitor C is adjusted, so that the equivalent area of the capacitor C is greater than the equivalent area of the selector S, but an occupied area of the capacitor C is the same as an occupied area of the selector S, to reduce an occupied area of the memory cell 200 and improve the storage density of the memory 300.

In some embodiments, the capacitor C is a dielectric capacitor.

In some other embodiments, the capacitor C is a ferroelectric capacitor.

The ferroelectric capacitor has remnant polarization (remnant polarization, Pr). In comparison with the dielectric capacitor, including the ferroelectric capacitor by the memory cell 200 may further increase the storage window and improve accuracy of writing. In addition, the ferroelectric capacitor has a good retention characteristic, and therefore can implement non-volatile storage.

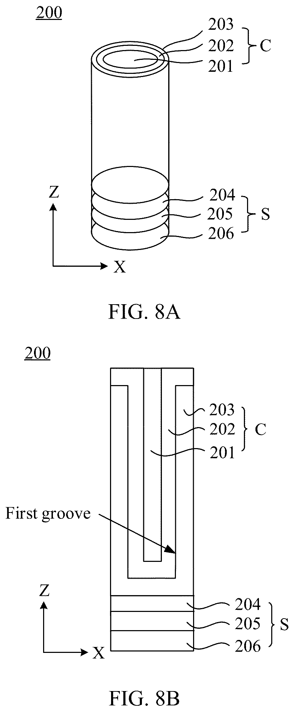

FIG. 8A to FIG. 8C are diagrams of structures of the capacitor according to embodiments of this application.

In some embodiments, as shown in FIG. 8A, the capacitor C includes a first electrode 201, a ferroelectric layer 202, and a second electrode 203, where the ferroelectric layer 202 is located between the first electrode 201 and the second electrode 203.

For example, as shown in FIG. 8A, the first electrode 201 is columnar, and the second electrode 203 is located at a periphery of the first electrode 201.

The capacitor C is made into a column shape, which occupies a small area and has a large equivalent area, and is conducive to improving storage density.

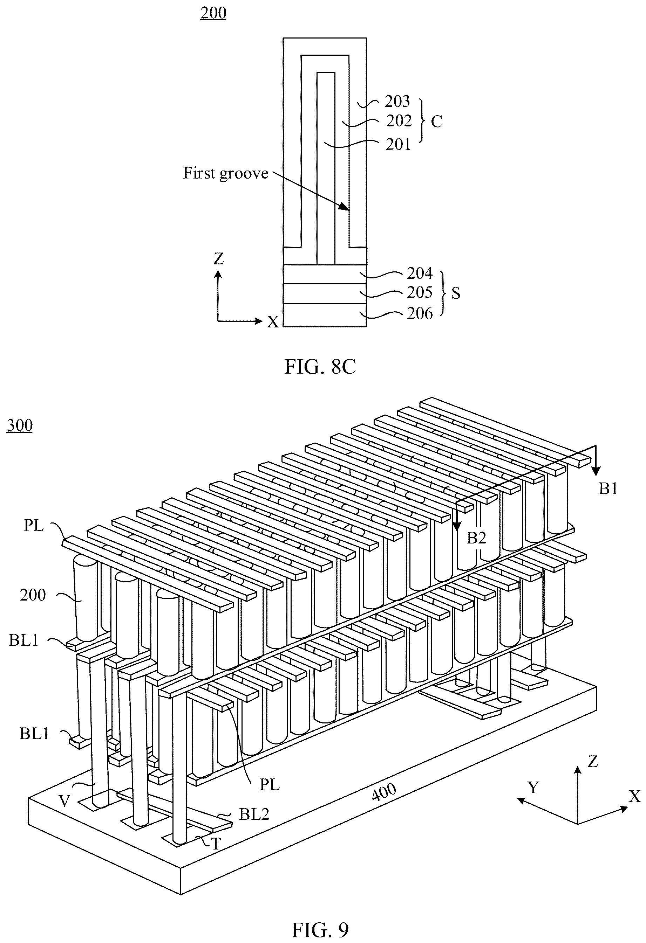

Alternatively, for example, as shown in FIG. 8B and FIG. 8C, a first groove is formed by enclosing the second electrode 203, and the ferroelectric layer 202 and the first electrode 201 are located in the first groove.

Compared with the first electrode 201 disposed as a U-shaped structure, the first electrode 201 disposed as a solid structure can reduce an area occupied by the capacitor C. This helps further improve the storage density of the memory 300.

Certainly, the capacitor may alternatively be a capacitor of another structure. FIG. 8A to FIG. 8C in embodiments of this application are merely examples.

In embodiments of this application, the ferroelectric layer 202 may be of a single-film structure, or the ferroelectric layer 202 may be of a multi-film structure. A material of the ferroelectric layer 202 includes a ferroelectric material or an anti-ferroelectric material. When the ferroelectric layer 202 is of the multi-film structure, materials of a plurality of layers may be the same or may be different.

In some embodiments, the ferroelectric layer 202 is made of a hafnium oxide-based material.

In comparison with that of a capacitor made of another ferroelectric material, a thickness size of a hafnium oxide-based capacitor C may be miniaturized to 10 nanometers or even sub-ten nanometers. In this way, high-density integration and even three-dimensional integration can be implemented, and the hafnium oxide-based capacitor C has a larger advantage in constructing an ultra-high-density memory chip. In addition, a preparation process of the hafnium oxide-based capacitor C may be well compatible with a silicon-based semiconductor process. In this way, the capacitor C may be prepared by using a mature manufacturing process, and manufacturing costs are not increased.

For example, the hafnium oxide-based material may be a ferroelectric material that is based on a hafnium oxide (hafnium oxide, HfO₂) material system. For example, the material of the ferroelectric layer 202 may be zirconium (Zr)-doped hafnium dioxide (HfO₂), silicon (Si)-doped HfO₂, aluminum (Al)-doped HfO₂, lanthanum (La)-doped HfO₂, yttrium (Y)-doped HfO₂, gadolinium (Gd)-doped HfO₂, or strontium (Sr)-doped HfO₂.

Alternatively, the hafnium oxide-based material may be a ferroelectric material in a hafnium zirconium oxide (hafnium zirconium oxide, HZO) material system. For example, the material of the ferroelectric layer 202 may be lanthanum (La)-doped HZO, yttrium (Y)-doped HZO, strontium (Sr)-doped HZO, gadolinium (Gd)-doped HZO, or gadolinium/lanthanum (Gd/La)-doped HZO. Alternatively, a doped element may be one or more of nitrogen, iron, lutetium, praseodymium, germanium, scandium, cerium, neodymium, magnesium, barium, indium, gallium, calcium, and carbon.

Alternatively, the hafnium oxide-based material may be a ferroelectric material in a material system like hafnium silicon oxygen, hafnium aluminum oxygen, hafnium lanthanum oxygen, hafnium zirconium lanthanum oxygen, hafnium zirconium cerium oxygen, hafnium zirconium yttrium oxygen, or hafnium zirconium gadolinium oxygen.

In this embodiment of this application, materials of the first electrode 201 and the second electrode 203 each may include, for example, a metal, a metal nitride, a metal carbide, a conductive metal nitride, a conductive metal oxide, or a combination thereof. The materials of the first electrode 201 and the second electrode 203 may be the same, or may be different.

For example, the materials of the first electrode 201 and the second electrode 203 each may include, for example, titanium (Ti), titanium nitride (TiN), tantalum nitride (TaN), titanium carbon nitride (TiCN), tantalum carbon nitride (TaCN), wolfram (W), wolfram nitride (WN), ruthenium (Ru), iridium (Ir), ruthenium oxide (RuO₂), niobium nitride (NbN), molybdenum nitride (MoN), iridium oxide (IrO₂), silicon (Si), germanium (Ge), silicon germanium (SiGe), or a combination thereof.

The ferroelectric layer 202 in the capacitor C has ferroelectricity. Therefore, the ferroelectric layer 202 has spontaneous polarization within a specific temperature range, and a spontaneous polarization direction of the ferroelectric layer 202 may be reversed due to a reverse direction of an external electric field. In this way, when the first electrode 201 and the second electrode 203 receive a voltage signal and generate an electric field, the electric field generated by the first electrode 201 and the second electrode 203 is applied to the ferroelectric layer 202. A crystal in a ferroelectric phase is formed in the ferroelectric layer 202, and when an electric field is applied to the ferroelectric layer 202, a central atom of the crystal stops in a low-energy state in a direction of the electric field. When a reversed electric field is applied to the ferroelectric layer, the central atom moves in the crystal in the direction of the electric field and stops in another low-energy state. A large quantity of central atoms move and are coupled in a unit cell of the crystal to form a ferroelectric domain (ferroelectric domain), and a polarization charge is formed in the ferroelectric domain under an action of the electric field. In a case of the reversed electric field, directional reversal occurs in the ferroelectric domain, and polarization charge energy formed in the ferroelectric domain before and after the reversed electric field is different. Such a binary stable state (positive and negative polarization states) enables the capacitor C to be charged and discharged, and can be identified by an external sense amplifier (sense amplifier, SA for short), to determine that the memory cell 200 is in a "0" or "1" storage state, so as to read data from or write data into a ferroelectric memory.

Continue to refer to FIG. 8A to FIG. 8C. For a structure of the selector S, in some embodiments, as shown in FIG. 8A to FIG. 8C, the selector S includes a third electrode 204, a resistive switching layer 205, and a fourth electrode 206. The third electrode 204, the resistive switching layer 205, and the fourth electrode 206 are disposed in a stacked manner in a direction away from the third direction Z, and the resistive switching layer 205 is disposed between the third electrode 204 and the fourth electrode 206.

In embodiments of this application, for materials of the third electrode 204 and the fourth electrode 206, refer to the foregoing related descriptions of the materials of the first electrode 201 and the second electrode 203.

The resistive switching layer 205 has a characteristic that a current flowing through the resistive switching layer 205 changes nonlinearly and reversibly as a resistance changes due to a change of an applied voltage.

For example, the current flowing through the resistive switching layer 205 increases nonlinearly as the resistance decreases due to an increase in the applied voltage. Reversibly, the current flowing through the resistive switching layer 205 decreases nonlinearly as the resistance increases due to a decrease in the applied voltage.

Alternatively, for example, the current flowing through the resistive switching layer 205 increases nonlinearly as the resistance decreases due to a decrease in the applied voltage. Reversibly, the current flowing through the resistive switching layer 205 decreases nonlinearly as the resistance increases due to an increase in the applied voltage.

In some embodiments, as the applied voltage changes, the resistance of the resistive switching layer 205 changes, and the resistive switching layer 205 reversibly enters a high resistance state or a low resistance state.

For example, when the resistance of the resistive switching layer 205 is greater than 1E9 ohm, it is determined that the selector S is in the high resistance state. When the resistance of the resistive switching layer 205 is less than 1E7 ohm, it is determined that the resistive switching layer 205 is in the low resistance state.

In a possible implementation, the resistive switching layer 205 is made of a material having a characteristic that a resistance varies with a voltage.

For example, the material of the resistive switching layer 205 may be a resistive switching layer that is applicable to a resistive random access memory in a technology in the art, or may be another specific material having a characteristic that a resistance varies with a voltage.

In some embodiments, the material of the resistive switching layer 205 includes a phase-change material.

The phase-change material has low resistance performance in a crystalline state, and has high resistance performance in a non-crystalline state. Therefore, the memory cell 200 may be selected by performing a set operation of switching a state of the phase-change material from a high-resistance non-crystalline state to a low-resistance crystalline state and a reset operation of switching the state of the phase-change material from the low-resistance crystalline state to the high-resistance non-crystalline state.

In some embodiments, the material of the resistive switching layer 205 includes silicon (Si) or a silicon compound, germanium (Ge) or a germanium compound, or any combination thereof.

The silicon compound may be, for example, silicon sulfide, silicon oxide, silicon nitride, or silicon carbide. The germanium compound may be, for example, germanium sulfide, germanium oxide, germanium nitride, or germanium carbide.

In some embodiments, the material of the resistive switching layer 205 includes one or more of silicon, antimony (Sb), tellurium (Te), bismuth (Bi), indium (In), stannum (Sn), selenium (Se), and the like. For example, the material of the resistive switching layer 205 may be germanium-silicon antimony-tellurium (Ge-Sb-Te (GST)), and may be Ge2Sb2Te5, Ge2Sb2Te7, Ge1Sb2Te4, Ge1Sb4Te7, or the like. A chemical composition ratio of the resistive switching layer 205 may be determined by considering properties such as a melting point and a crystallization temperature.

In some embodiments, the material of the resistive switching layer 205 includes a metal oxide.

For example, the material of the resistive switching layer 205 includes at least one of tantalum oxide (Ta₂O₅), niobium oxide (Nb₂O₅), titanium dioxide (TiO₂), hafnium dioxide (HfO₂), or indium gallium zinc oxide (indium gallium zinc oxide, IGZO).

Alternatively, for example, the material of the resistive switching layer 205 includes a lanthanum oxide. The lanthanum oxide is an oxide including a lanthanum element. For example, the material of the resistive switching layer 205 includes lanthanum oxide (La₂O₃) and praseodymium oxide (Pr₆O₁₁).

In some embodiments, the material of the resistive switching layer 205 includes a material having a metal-insulator transition characteristic.

The metal-insulator transition (metal-insulator transition, MIT) is physical transition from a metal conductor to a non-conductive insulator (or semiconductor), or physical transition from an insulator to a conductor. The material of the resistive switching layer 205 has a characteristic that the resistance decreases nonlinearly as the voltage increases. Therefore, the material of the resistive switching layer 205 in embodiments of this application has a characteristic that the material of the resistive switching layer 205 is an insulator at a low voltage and is a metal at a high voltage.

For example, the material of the resistive switching layer 205 includes vanadium dioxide (VO₂), niobium dioxide (NbO₂), titanium dioxide (TiO₂), and tungsten dioxide (WO₂).

In some embodiments, the material of the resistive switching layer 205 includes a mixed ionic-electronic conductor (mixed ionic-electronic conductor, MIEC) material.

The MIEC material is a conductor in which both ionic conduction and electronic conduction exist. The MIEC material, also referred to as a mixed conductor (mixed conductor) material, is a solid material between an ion conductor and an electronic conductor, and has both ionic conductivity and electronic conductivity.

For example, the material of the resistive switching layer 205 includes ceramic (ZrO₂ (Y₂O₃)), bismuth oxide-barium oxide composite oxide (Bi₂O₃-BaO), and lanthanum oxide-cerium oxide composite oxide ((La₂O₃)ₓ(CeO₂)₁₋ₓ).

In some embodiments, the material of the resistive switching layer 205 includes a perovskite-type composite oxide.

A general formula of the perovskite-type composite oxide is ABO₃. The perovskite-type composite oxide is a new inorganic non-metallic material with unique physical and chemical properties. A is generally a rare earth or alkaline earth element ion, and B is a transition element ion. Both A and B can be partially replaced by other metal ions with similar radiuses to keep crystal structures of A and B basically unchanged.

For example, the material of the resistive switching layer 205 includes doped strontium titanate (SrTiO₃), barium titanate (BaTiO₃), and lanthanum manganate (LaMnO₃).

In some embodiments, the material of the resistive switching layer 205 includes a solid electrolyte.

The solid electrolyte is an object that presents ionic conductivity in a solid state (that is, below the melting point).

For example, the material of the resistive switching layer 205 includes sulfides such as germanium sulfide (GeₓS_{y}), silver sulfide (Ag₂S), and copper sulfide (Cu₂S), iodides such as silver iodide (AgI) and rubidium silver iodide (RbAg₄I₅), a selenide like germanium selenide (GeₓSe_{y}), and tellurides such as germanium telluride (GeₓTe_{y}), antimony telluride (SbₓTe_{y}), germanium-antimony-tellurium (GeSbTe), and silver-indium-antimony-tellurium (AgInSbTe).

In some embodiments, the material of the resistive switching layer 205 includes an organic polymer.

The organic polymer is a macromolecule that includes one or more organic molecules or molecular groups that are covalently bonded and that includes a plurality of repeating monomer units.

For example, the material of the resistive switching layer 205 includes poly(ethyl methacrylate) (poly(ethyl methacrylate), PEMA), polyazomethine (polyazomethine, PAM), polytriphenylamine (polytriphenylamine, PTPA), or poly[2,7-(9,9-dihexylfluorene)]-block-poly(pendent isoindigo) (poly[2,7-(9,9-dihexylfluorene)]-block-poly(pendent isoindigo), PF₁₄-b-Pisoₙ).

For a material with a resistive switching property, an oxygen vacancy channel or a metal ion channel is formed or cut off when an externally applied voltage changes.

For example, when the voltage is small, the oxygen vacancy channel or the metal ion channel is slowly formed, and the resistance of the resistive switching layer 205 is large. When the voltage is large, the oxygen vacancy channel or the metal ion channel is quickly formed, and the resistance of the resistive switching layer 205 rapidly decreases.

In some embodiments, the material of the resistive switching layer 205 includes any combination of the foregoing materials.

In another implementation, the resistive switching layer 205 is a selection element, the resistive switching layer 205 is an element having a resistive switching property, and the resistive switching layer 205 controls flow of a current based on a value of an applied voltage or current.

When the value of the applied voltage or current is a predetermined critical value or less, the resistive switching layer 205 makes the current almost not flow; or when the value of the applied voltage or current exceeds a predetermined critical value, the resistive switching layer 205 makes the current rapidly increase in proportion to the value of the applied voltage or current for flowing. For example, when the voltage applied to the resistive switching layer 205 exceeds a threshold voltage (for example, 1/2 Vcc), the resistive switching layer 205 is in the low resistance state; or when the voltage applied to the resistive switching layer 205 is less than a threshold voltage, the resistive switching layer 205 is in the high resistance state.

In some embodiments, the resistive switching layer 205 includes a PNP junction or an NPN junction.

In some embodiments, the resistive switching layer 205 includes a back-to-back Schottky junction.

In some embodiments, the resistive switching layer 205 includes an ovonic threshold switch (ovonic threshold switch, OST).

For example, the resistive switching layer 205 may be an ovonic threshold switch (OST) element, and includes a material based on a chalcogenide like arsenic telluride (As₂Te₃), arsenic (As2), or arsenic selenide (As₂Se₃), or includes TiO₂, titanium sub-oxide (Ti₄O₇), tantalum dioxide (TaO₂), tantalum pentoxide (Ta₂O₅), nickel peroxide (NiO₂), HfO₂, Ge, Sb, and Te.

Continue to refer to FIG. 5. Based on the foregoing structure, the memory 300 further includes the plurality of transistors T.

Each transistor includes a first electrode t1, a second electrode t2, and a control electrode t3. The transistor T is, for example, a complementary metal oxide semiconductor (complementary metal oxide semiconductor, CMOS) transistor. In this case, the first electrode t1 and the second electrode t2 may be, for example, a source and a drain of the transistor T, and the control electrode t3 may be, for example, a gate of the transistor T.

In some embodiments, the plurality of first electrodes t1 of the plurality of transistors T are correspondingly coupled to the plurality of first bit lines BL1.

For example, as shown in FIG. 5, a quantity of transistors T is the same as that of first bit lines BL1.

For example, the memory 300 includes six first bit lines BL1 and six transistors T. In this case, six first electrodes t1 of the six transistors T are coupled to the six first bit lines BL1 in a one-to-one correspondence.

In some embodiments, the plurality of second electrodes t2 of the plurality of transistors T are correspondingly coupled to the at least one second bit line BL2.

For example, the memory 300 includes one second bit line BL2. In this case, the second electrode t2 of each transistor T is coupled to the second bit line BL2.

In this way, the second bit line BL2 is used to simultaneously transmit signals to the plurality of memory cells 200. This can reduce a quantity of second bit lines BL2, and simplify a structure of the memory 300.

Alternatively, for example, as shown in FIG. 5, the memory 300 includes the plurality of second bit lines BL2.

Optionally, the quantity of second bit lines BL2 is less than the quantity of transistors T. In FIG. 5, an example in which the memory 300 includes two second bit lines BL2 is used for illustration. In this case, the second electrodes t2 of the plurality of transistors T are correspondingly coupled to the two second bit lines BL2.

In this case, at least two transistors T are coupled in parallel to each second bit line BL2.

For example, in the six transistors T in FIG. 5, second electrodes of three transistors T are coupled to one second bit line BL2, and second electrodes of the other three transistors are coupled to another second bit line BL2.

Certainly, it should be understood that the two second bit lines BL2 may be coupled at a location in the memory 300, to receive a same signal. Alternatively, the two second bit lines BL2 may not be coupled. This is not limited in embodiments of this application.

In this way, the at least two transistors T are connected in parallel to each second bit line BL2, and each second bit line BL2 is used to simultaneously transmit a signal for at least two memory cells 200. This can reduce the quantity of second bit lines BL2, and simplify the structure of the memory 300.

Alternatively, optionally, the quantity of second bit lines BL2 is equal to the quantity of transistors T. In this case, the second electrodes t2 of the plurality of transistors T are coupled to the plurality of second bit lines BL2 in a one-to-one correspondence.

In this case, one transistor T is coupled to each second bit line BL2.

In some embodiments, the plurality of control electrodes t3 of the plurality of transistors T are correspondingly coupled to the at least one word line WL.

For example, at least two transistors T are coupled to each word line WL.

In this way, each word line WL simultaneously controls the at least two transistors T. This can reduce the quantity of word lines WLs, and simplify the structure of the memory 300.

A coupling manner of the transistor T and the at least one word line WL may be the same as a coupling manner of the transistor T and the at least one second bit line BL2. Refer to the foregoing related descriptions. Details are not described herein again.

For example, the second electrodes t2 of the plurality of transistors T are coupled to the plurality of second bit lines BL2 in the one-to-one correspondence, and the control electrodes t3 of the plurality of transistors T are coupled to the plurality of word lines WLs in a one-to-one correspondence.

Alternatively, for example, the second electrodes t2 of the plurality of transistors T are coupled to the plurality of second bit lines BL2 in the one-to-one correspondence, and the control electrodes t3 of the plurality of transistors T are correspondingly coupled to one or at least two word lines WLs (a quantity of word lines WLs is less than the quantity of transistors).

It may also be understood that the at least two transistors T are coupled in parallel to each word line WL, but each second bit line BL2 is coupled to only one transistor T.

Alternatively, for example, the second electrodes t2 of the plurality of transistors T are correspondingly coupled to one or at least two second bit lines BL2 (the quantity of second bit lines BL2 is less than the quantity of transistors), and the control electrodes t3 of the plurality of transistors T are coupled to the plurality of word lines WLs in the one-to-one correspondence.

It may also be understood that at least two transistors T are coupled in parallel to each second bit line BL2, but each word line WL is coupled to only one transistor T.

Alternatively, for example, the second electrodes t2 of the plurality of transistors T are correspondingly coupled to one or at least two second bit lines BL2 (the quantity of second bit lines BL2 is less than the quantity of the transistors), and the control electrodes t3 of the plurality of transistors T are correspondingly coupled to one or at least two word lines WLs (the quantity of word lines WLs is less than the quantity of transistors).

It may also be understood that at least two transistors T are coupled in parallel to each word line WL, and at least two transistors T are coupled in parallel to each second bit line BL2.

The plurality of transistors T are correspondingly coupled to at least two second bit lines BL2, so that each second bit line BL2 may be correspondingly coupled to the plurality of transistors T in parallel. This can reduce the quantity of second bit lines BL2, and helps further improve the storage density of the memory 300. Similarly, the plurality of transistors T are correspondingly coupled to at least two word lines WLs, so that each word line WL may be correspondingly coupled to the plurality of transistors T in parallel. This can reduce the quantity of second bit lines BL2, and helps further improve the storage density of the memory 300.

For a coupling manner of the transistor T and each signal line, as shown in FIG. 5, in some embodiments, the first bit line BL1 is coupled to the first electrode t1 of the transistor T through the conductive via V.

For example, the conductive via V is located between the first bit line BL1 and the first electrode t1.

In some embodiments, the conductive via V is disposed close to the end of the first bit line BL1, and correspondingly, the transistor T is also located under the end of the first bit line BL1.

For example, as shown in FIG. 5, the plurality of transistors T are distributed at two ends of the first bit line BL1.

Alternatively, for example, the plurality of transistors T are distributed at a same end of the first bit line BL1.

In some other embodiments, the conductive via V is not disposed close to the end of the first bit line BL1, and correspondingly, the transistor T is not located under the end of the first bit line BL1.

For example, the transistor T is located below a middle region of the first bit line BL1.

A relative location relationship between the conductive via V of the transistor T and the first bit line BL1 is not limited in embodiments of this application, and the accompanying drawing is merely an example.

Certainly, a shape of the conductive via V is not limited in embodiments of this application. For example, the conductive via V may be cylindrical.

In some embodiments, the memory 300 further includes a controller (not shown in FIG. 5). The controller is separately coupled to the second bit line BL2, the plate line PL, and the word line WL, and is configured to provide a read/write signal for the second bit line BL2, the plate line PL, and the word line WL.

In some embodiments, a transistor included in the controller and the transistor T are synchronously formed on the substrate 400.

For example, the capacitor C is a ferroelectric capacitor. A principle of the ferroelectric memory 300 in this embodiment of this application is as follows:

The memory cell 200 stores information by using a polarization direction of the capacitor C. For example, when the polarization direction of the capacitor C is positive, the stored information is "0". When the polarization direction of the capacitor C is negative, the stored information is "1". Reading or writing of the stored information are performed by using a read/write voltage to control a switch of the selector S. Through voltage regulation and control of the first bit line BL1 and the plate line PL, a memory cell 200 in the memory 300 may be selected and a corresponding read/write operation may be performed. Writing of the information is to change the polarization direction of the capacitor C in the memory cell 200 by applying voltage differences of different polarities to the memory cell 200, so as to store the information. Reading of the information depends on applying a voltage to the memory cell 200, and reading a corresponding current on the plate line PL of the memory cell 200. A value of the read current varies with the stored information.

A read/write process of the memory 300 provided in this embodiment of this application is as follows:

Through voltage regulation and control of the first bit line BL1 and the plate line PL, a memory cell 200 may be selected and a corresponding read/write operation may be performed. Writing of the information is to change the polarization direction of the capacitor C in the memory cell 200 by applying voltage differences of different polarities to the memory cell 200, so as to store the information. Reading of the information depends on applying a voltage to the memory cell 200, and reading a corresponding current on the plate line PL of the memory cell 200. A value of the read current varies with the stored information.

For example, a write (write) operation includes two cases: writing "0" and writing "1".

When "0" is written, an (n, m)^{th} memory cell 200 is selected, to be specific, a voltage of an n^{th} first bit line BL1 is Vc, a voltage of an m^{th} plate line PL is 0, and voltages of the other first bit lines BL1 and the plate line PL are all Vc/2. In this case, a voltage applied to a resistive switching layer 205 of a selector S in the selected memory cell 200 is greater than a turn-on threshold voltage of the resistive switching layer 205, the resistive switching layer 205 is in a low resistance state, and the selector S in the selected memory cell 200 is turned on. However, voltages applied to resistive switching layers 205 of selectors S in the other unselected memory cells 200 are less than or equal to 1/2 of the operating voltage, the resistive switching layer 205 is in a high resistance state, and the unselected memory cell 200 is not turned on. The selected (n, m)^{th} memory cell 200 is biased by a forward voltage with a value of Vc, and a ferroelectric layer 202 in a capacitor C inside the memory cell 200 performs forward polarization, that is, writing "0" is completed.

When "1" is written, an (n, m)^{th} memory cell 200 is selected, to be specific, a voltage of an n^{th} first bit line BL1 is 0, a voltage of an m^{th} plate line PL is Vc, and voltages of the other first bit lines BL1 and the plate line PL are all Vc/2. Similarly, a voltage applied to a resistive switching layer 205 of a selector S in the selected memory cell 200 is greater than a turn-on threshold voltage of the resistive switching layer 205, the resistive switching layer 205 is in a low resistance state, and the selector S in the selected memory cell 200 is turned on. However, voltages applied to resistive switching layers 205 of selectors S in the other unselected memory cells 200 are less than or equal to 1/2 of the operating voltage, the resistive switching layer 205 is in a high resistance state, and the unselected memory cell 200 is not turned on. The selected (n, m)^{th} memory cell 200 is biased by a reverse voltage with a value of Vc, and a ferroelectric layer 202 in a capacitor C inside the memory cell 200 performs reverse polarization, that is, writing "1" is completed.

A read (read) operation is divided into two steps. A first step is reading and a second step is writing back.

During reading, the (n, m)^{th} memory cell 200 is selected, to be specific, the voltage of the n^{th} first bit line BL1 is Vc, the voltage of the m^{th} plate line PL is first pre-charged to a potential of 0, and then switched to a floating (floating) state, and the voltages of the other first bit lines BL1 and the plate line PL are all Vc/2. The voltage applied to the resistive switching layer 205 of the selector S in the selected memory cell 200 is greater than the turn-on threshold voltage of the resistive switching layer 205, the resistive switching layer 205 is in the low resistance state, and the selector S in the selected memory cell 200 is turned on. However, the voltages applied to the resistive switching layers 205 of the selectors S in the other unselected memory cells 200 are less than or equal to 1/2 of the operating voltage, the resistive switching layer 205 is in the high resistance state, and the unselected memory cell 200 is not turned on. The selected (n, m)^{th} memory cell 200 is biased by a voltage with a value of Vc, and a transient current flows from the n^{th} first bit line BL1 to the m^{th} plate line PL. If the ferroelectric polarization direction stored in the memory cell 200 is opposite to a voltage bias direction, the ferroelectric layer 202 performs polarization switching, and a polarization switching current flows through the m^{th} plate line PL. On the contrary, if the ferroelectric polarization direction stored in the memory cell 200 is the same as the voltage bias direction, the ferroelectric layer 202 does not perform polarization switching, and the m^{th} plate line PL does not have the polarization switching current.

After the read operation is complete, 0 or 1 is written back based on the original stored information before the read operation. The write-back operation is the same as the foregoing write operation.

In the memory 300 provided in this embodiment of this application, the memory cell 200 is of the 1S1C structure including the selector S and the capacitor C, and the selector S is used as a switch to control whether to select a memory cell 200. In comparison with a memory cell 200 of a 1T1C structure, the memory cell 200 of the 1S1C structure does not need to have a corresponding transistor disposed in each memory cell 200. This can reduce the quantity of transistors, and help improve the storage density of the memory. In addition, dependence on an advanced process node can be reduced, and process difficulty and process costs can be reduced. In addition, in the memory 300, a front end of a memory array has a first-level switch transistor T, and the transistor T is configured to select the memory array. In an architecture of the memory 300 provided in this embodiment of this application, the second electrode of each transistor T is coupled to one first bit line BL1, and each first bit line BL1 is coupled to at least two memory cells 200. Because the selector S is the two-terminal device, the selector S is turned on only when a piezoelectric difference between two terminals of the selector S is greater than a specific value. In this case, even if a same transistor T simultaneously transmits a read/write signal to the first bit lines BL1 of the plurality of memory cells 200, a plate line PL of the unselected memory cell 200 is not used to transmit the read/write signal, and the unselected memory cell 200 is not turned on. This can effectively avoid the crosstalk. Furthermore, both the memory cell 200 and the transistor T in this application may be manufactured by using a conventional process, and are highly compatible with the conventional process and a conventional architecture. Therefore, process difficulty is low. Therefore, according to the memory 300 provided in this embodiment of this application, both high storage density and anti-crosstalk performance can be considered, and performance of the memory 300 can be improved.

### Example 2

A main difference between Example 2 and Example 1 lies in that the memory cells 200 are arranged into a plurality of layers in a third direction Z.

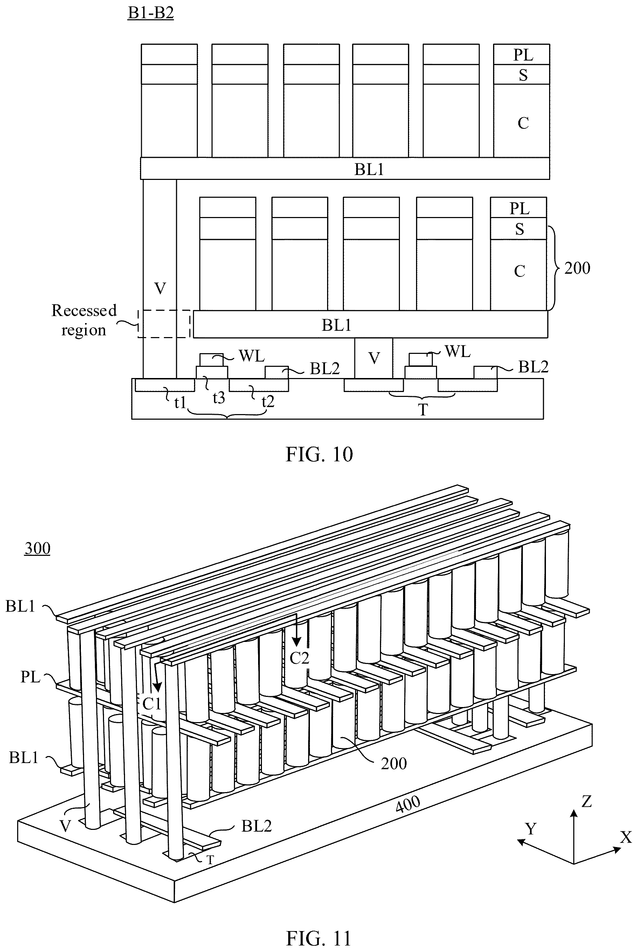

FIG. 9 is a three-dimensional diagram of a memory 300 according to an embodiment of this application. FIG. 10 is a cross-sectional view along a direction from B1 to B2 in FIG. 9.

As shown in FIG. 9 and FIG. 10, an embodiment of this application further provides a memory 300. The memory 300 includes a plurality of first bit lines BL1, at least one second bit line BL2, a plurality of plate lines PLs, at least one word line WL (not shown in FIG. 9), memory cells 200, and transistors T that are disposed on a same side of a substrate 400.

In some embodiments, an arrangement manner of the plurality of first bit lines BL1 is basically the same as that in Example 1, and a main difference lies in that in Example 2, the plurality of first bit lines BL1 are distributed in a plurality of layers in a third direction Z.

For an arrangement manner of the at least one second bit line BL2 included in the memory 300, refer to the related descriptions in Example 1. Details are not described herein again.

An arrangement manner of the plurality of plate lines PLs included in the memory 300 is basically the same as that in Example 1, and a main difference lies in that in Example 2, the plurality of plate lines PLs are distributed in a plurality of layers in the third direction Z. In FIG. 9, an example in which the plurality of memory cells 200 are arranged in two layers in the third direction Z is used for illustration.

For an arrangement manner of the at least one word line WL included in the memory 300, refer to the related descriptions in Example 1. Details are not described herein again.

As shown in FIG. 9, the plurality of memory cells 200 are distributed in a plurality of layers in the third direction Z, and an arrangement manner of at least two memory cells 200 in each layer may be the same as that in Example 1.

For example, the plurality of memory cells 200 are distributed in the plurality of layers in the third direction Z, and the at least two memory cells 200 at each layer are distributed in a plurality of rows and a plurality of columns.

For example, the memory cells 200 at each layer are arranged in a honeycomb manner, and are arranged into a plurality of layers in the third direction Z in a same manner.

In some embodiments, for the memory cell 200 at each layer, in the third direction Z, the plate line PL and the first bit line BL1 are correspondingly disposed on two sides of the memory cell 200.

Certainly, a selector S in the memory cell 200 may be coupled to the plate line PL, and a memory C may be coupled to the first bit line BL1. Alternatively, a selector S in the memory cell 200 may be coupled to the first bit line BL1, and a memory C may be coupled to the plate line PL. FIG. 9 is only an example.

In some embodiments, each layer of memory cells 200 are coupled to a first bit line BL1 located on a side that is of the memory cell 200 at the layer and that is away from a transistor T.

In some other embodiments, as shown in FIG. 10, each layer of memory cells 200 are coupled to a first bit line BL1 located on a side that is of the memory cell 200 at the layer and that is close to a transistor T.

In this way, the memory cell 200 is located over the first bit line BL1, and a conductive via V is located under the first bit line BL1. In this case, on one hand, the memory cell 200 may also be arranged above the conductive via V, to further improve storage density of the memory 300. On the other hand, in contrast to arranging the first bit line BL1 over the memory cell 200 arranging the first bit line BL1 under the memory cell 200 may make the conductive via V close to the substrate 400, and the conductive via V has a shallow depth. A preparation process is simple.

With reference to FIG. 9 and FIG. 10, in the memory 300, a plurality of first electrodes t1 of the plurality of transistors T are correspondingly coupled to the plurality of first bit lines BL1, a plurality of second electrodes t2 of the plurality of transistors T are correspondingly coupled to the at least one second bit line BL2, and a plurality of control electrodes t3 of the plurality of transistors T are correspondingly coupled to the at least one word line WL.

An arrangement manner of the plurality of transistors T and a coupling manner of the plurality of transistors T and the signal lines are the same as those in Example 1, except that the plurality of first bit lines BL1 correspondingly coupled to the plurality of first electrodes tl of the plurality of transistors T are arranged into a plurality of layers instead of being arranged into one layer.

In this embodiment of this application, because no transistor T needs to be disposed in the memory cell 200, a small quantity of transistors T are disposed in a region under the memory cells 200. Therefore, even if the memory cells 200 are stacked in a three-dimensional manner in the third direction Z, the region under the memory cells 200 is sufficient to dispose transistors T required in the memory 300. The memory cells 200 are stacked in the three-dimensional manner in the third direction Z, so that a quantity of memory cells 200 may be increased, but an area occupied by the memory cells 200 in a plane parallel to the substrate 400 is not increased. This can increase a quantity of disposed memory cells 200 in a unit area, and help improve the storage density of the memory 300.

In some embodiments, as shown in FIG. 10, the first bit line BL1 is coupled to the first electrode t1 of the transistor T through the conductive via V.

In some embodiments, the first bit lines BL1 located at the same layer are arranged in a manner of non-flush ends.

For example, refer to FIG. 7A. In at least two first bit lines BL1 located at a same layer, an end of at least one first bit line BL1 is recessed relative to an end of a first bit line BL1 adjacent to the at least one first bit line BL1 to form a recessed region.

The first bit lines BL1 corresponding to the recessed region is referred to as a recessed group. In FIG. 7A, an example in which the recessed group includes one first bit line BL1 is used for illustration. Alternatively, the recessed group may include two or more first bit lines BL1, and ends of first bit lines BL1 in a same recessed group may be flush or may not be flush.

Based on the foregoing arrangement manner, in some embodiments, a conductive via V that starts to extend from a side that is of the recessed region and that is away from the transistor T passes through the recessed region.

In other words, lower-layer first bit lines BL1 are arranged in a manner of non-flush ends, and when a conductive via V coupled to an upper-layer first bit line BL1 extends downward from the upper-layer first bit line BL1 and is coupled to the transistor T, the conductive via V passes through a recessed region of the lower-layer first bit lines BL1.

For example, in FIG. 10, first-layer first bit lines BL1 close to the substrate 400 are arranged in a manner of non-flush ends, to form a recessed region. A layer of first bit lines BL1 located on a side that is of the first-layer first bit line BL1 and that is away from the substrate 400 are referred to as second-layer first bit lines BL1. A conductive via V coupled to the second-layer first bit line BL1 extends downward from an under part of the second-layer first bit line BL1 to the transistor T for coupling. The conductive via V is disposed corresponding to a recessed region, and the conductive via V passes through the recessed region in an extension process. It may also be understood that projection of the conductive via V on the substrate 400 falls within projection of the recessed region on the substrate 400.

When a layer of memory cells 200 are arranged in a manner of arranging two adjacent rows of memory cells 200 in a staggered manner, a column of memory cells 200 are not arranged in alignment. Therefore, ends of the first bit lines BL1 may also be arranged in a non-flush manner, to form a recessed region. On this basis, the conductive via V is coupled to the transistor T by passing through the recessed region. This can reduce an area occupied by the conductive via V, and help improve the storage density of the memory 300.

In some embodiments, refer to FIG. 7A. Two ends of one-layer first bit lines BL1 form a recessed region, and the recessed region may not correspond to a same first bit line BL1.

In this case, as shown in FIG. 9, conductive vias V are disposed on both sides of a memory array including the memory cells 200.

The conductive vias V are distributed on both sides, so that density of the transistor T and the conductive vias V can be reduced, to reduce process difficulty.

In some embodiments, the memory 300 provided in Example 2 may be understood as that the single-layer memory cells 200 provided in Example 1 and the transistors T and the signal lines that are coupled to the single-layer memory cells 200 are arranged into a plurality of layers in the third direction Z.

### Example 3

A main difference between Example 3 and Example 2 lies in that in Example 3, two adjacent layers of memory cells 200 share a plate line PL.

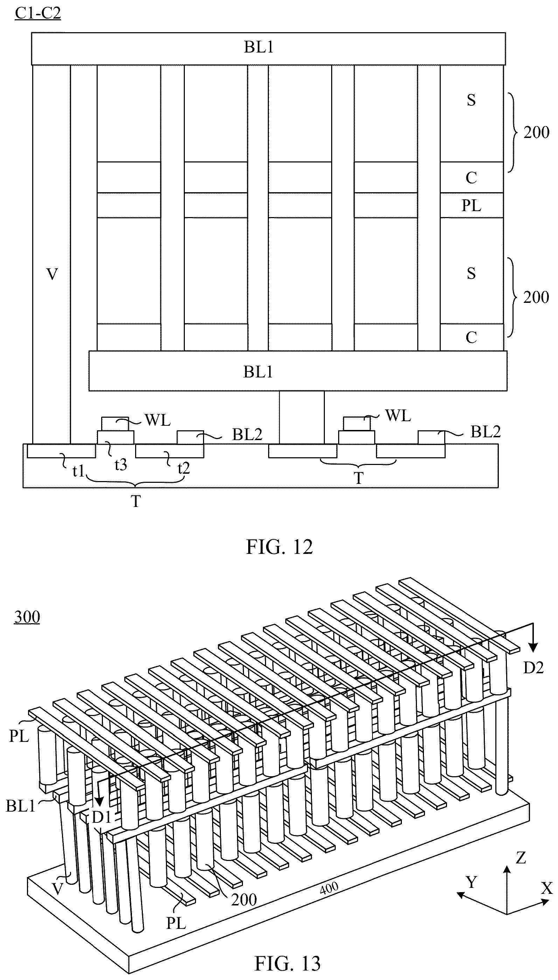

FIG. 11 is a three-dimensional diagram of a memory according to an embodiment of this application. FIG. 12 is a cross-sectional view along a direction from C1 to C2 in FIG. 11.

As shown in FIG. 11 and FIG. 12, a plurality of memory cells 200 are arranged into a plurality of layers in a third direction Z, a plate line PL is disposed between two adjacent layers of memory cells 200, and the two layers of memory cells 200 are all coupled to the plate line PL.

Alternatively, it is understood that the two adjacent layers of memory cells 200 share the plate line PL.

The two adjacent layers of memory cells 200 are enabled to share the plate line PL, so that a quantity of wiring layers can be reduced, to simplify a structure of the memory 300, and further improve storage density of the memory 300.

For example, second electrodes t2 of a plurality of transistors T are correspondingly coupled to one or at least two second bit lines BL2 (a quantity of second bit lines BL2 is less than a quantity of transistors), and control electrodes t3 of the plurality of transistors T are correspondingly coupled to one or at least two word lines WLs (a quantity of word lines WLs is less than the quantity of transistors).

It may also be understood that at least two transistors T are coupled in parallel to each word line WL, and at least two transistors T are coupled in parallel to each second bit line BL2.

In some embodiments, at least two transistors T coupled to a same second bit line BL2 are coupled to first bit lines BL1 located at a same layer.

It may also be understood that first bit lines BL1 that are not at a same layer does not receive a signal transmitted by using a same second bit line BL2.

In some embodiments, at least two transistors T coupled to a same word line WL are coupled to first bit lines BL1 located at a same layer.

It may also be understood that transistors T corresponding to the first bit lines BL1 that are not at the same layer are not controlled by a same word line WL.

In this way, crosstalk between memory cells 200 at different layers can be reduced, and performance of the memory 300 can be improved.

### Example 4

A main difference between Example 4 and Example 2 lies in that in Example 4, two adjacent layers of memory cells 200 share a first bit line BL1.

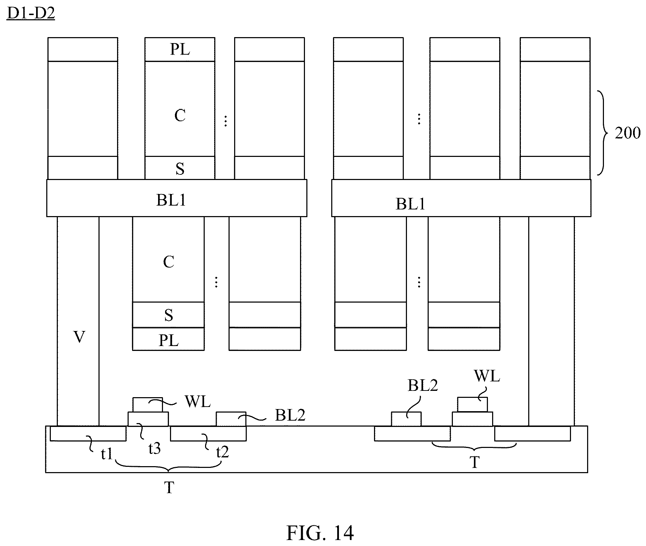

FIG. 13 is a three-dimensional diagram of a memory according to an embodiment of this application. FIG. 14 is a cross-sectional view along a direction from D1 to D2 in FIG. 13.

As shown in FIG. 13 and FIG. 14, a plurality of memory cells 200 are arranged into a plurality of layers in a third direction Z, a first bit line BL1 is disposed between two adjacent layers of memory cells 200, and the two layers of memory cells 200 are coupled to the first bit line BL1.

Alternatively, it is understood that the two adjacent layers of memory cells 200 share the first bit line BL1.

In some embodiments, a plate line PL is disposed on a side that is of a layer of memory cells 200 closest to a substrate 400 and that is close to the substrate 400, and a first bit line BL1 is disposed on a side that is of the layer of memory cells 200 and that is away from the substrate 400.

The two adjacent layers of memory cells 200 are enabled to share the first bit line BL1, so that a quantity of wiring layers can be reduced, to simplify a structure of the memory 300, and further improve storage density of the memory 300.

In some embodiments, memory cells 200 in a same row are coupled in parallel to one first bit line BL1.

In some other embodiments, as shown in FIG. 14, the memory cells 200 in the same row are coupled in parallel to at least two first bit lines BL1. In FIG. 14, an example in which the memory cells 200 in the same row are coupled in parallel to two first bit lines BL1 is used for illustration.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory, comprising:
a plurality of first bit lines, all extending in a first direction;
at least one second bit line, extending in a second direction, wherein the second direction intersects the first direction;
a plurality of plate lines, all extending in the second direction;
a plurality of memory cells, wherein the memory cell comprises a selector and a capacitor that are coupled in series, the plurality of memory cells are arranged in a plurality of rows and a plurality of columns, and the row direction is parallel to the first direction, wherein
the plurality of first bit lines and the plurality of plate lines are located on two sides of the memory cell, each first bit line is coupled to at least two memory cells located in a same row, and each plate line is coupled to at least two memory cells located in a same column; and
a plurality of transistors, wherein a plurality of first electrodes of the plurality of transistors are correspondingly coupled to the plurality of first bit lines, and a plurality of second electrodes of the plurality of transistors are correspondingly coupled to the at least one second bit line.

2. The memory according to claim 1, wherein the plurality of memory cells are further distributed in a plurality of layers in a third direction, and the third direction intersects both the first direction and the second direction.

3. The memory according to claim 2, wherein transistors coupled to a same second bit line are coupled to a first bit line located at a same layer.

4. The memory according to claim 2 or 3, wherein the first bit line is coupled to the first electrode of the transistor through a conductive via; and
at a same layer, an end of at least one first bit line is recessed relative to an end of a first bit line adjacent to the at least one first bit line to form a recessed region; and the conductive via that starts to extend from a side that is of the recessed region and that is away from the transistor passes through the recessed region.

5. The memory according to any one of claims 2 to 4, wherein two adjacent layers of memory cells share the plate line.

6. The memory according to any one of claims 1 to 5, wherein each layer of memory cells are coupled to a first bit line located on a side that is of the memory cell and that is close to the transistor.

7. The memory according to any one of claims 2 to 4, wherein two adjacent layers of memory cells share the first bit line.

8. The memory according to any one of claims 1 to 7, wherein memory cells located in a same row are correspondingly coupled to at least two first bit lines.

9. The memory according to any one of claims 1 to 8, wherein at least two transistors are coupled in parallel to each second bit line.

10. The memory according to any one of claims 1 to 9, wherein an equivalent area of the selector is less than an equivalent area of the capacitor.

11. The memory according to any one of claims 1 to 10, wherein projection of the selector in a plane parallel to the first direction and the second direction coincides with projection of the capacitor in the plane.

12. The memory according to any one of claims 1 to 11, wherein the capacitor comprises a ferroelectric capacitor.

13. The memory according to any one of claims 1 to 12, wherein the capacitor comprises a first electrode, a ferroelectric layer, and a second electrode; and the first electrode is columnar, the second electrode is located at a periphery of the first electrode, and the ferroelectric layer is located between the first electrode and the second electrode.

14. The memory according to any one of claims 1 to 13, wherein memory cells in two adjacent rows are arranged in a staggered manner.

15. The memory according to any one of claims 1 to 14, wherein the memory further comprises at least one word line, and a plurality of control electrodes of the plurality of transistors are correspondingly coupled to the at least one word line.

16. The memory according to any one of claims 1 to 15, wherein the memory further comprises a controller, and the controller is coupled to the second bit line and the plate line.

17. The memory according to any one of claims 1 to 16, wherein the selector comprises a resistive switching layer, a third electrode, and a fourth electrode, and the resistive switching layer is disposed between the third electrode and the fourth electrode.

18. An electronic device, comprising a circuit board and the memory according to any one of claims 1 to 17, wherein the circuit board is coupled to the memory.
